Europäisches Patentamt

European Patent Office

Office européen des brevets

(11) Veröffentlichungsnummer: **0 391 144**

**A2**

## (12) EUROPÄISCHE PATENTANMELDUNG

(21) Anmeldenummer: **90105379.3**

(22) Anmeldetag: **21.03.90**

(51) Int. Cl.⁵: **H03L 7/07, H03L 7/26**

(30) Priorität: **07.04.89 DE 3911428**

(43) Veröffentlichungstag der Anmeldung:
**10.10.90 Patentblatt 90/41**

(84) Benannte Vertragsstaaten:
**AT BE CH DE ES FR GB GR IT LI NL SE**

(71) Anmelder: **Siemens Aktiengesellschaft**
**Wittelsbacherplatz 2**
**D-8000 München 2(DE)**

(72) Erfinder: **Ernst, Wolfram, Dipl.-Ing.**
**Witthalmstrasse 9**
**D-8000 München 70(DE)**

(54) Verfahren zur Synchronisation einer Takteinrichtung eines getakteten elektrischen Systems.

(57) Zur Erfüllung erhöhter Anforderungen an die Frequenzstabilität der Taktversorgung eines getakteten elektrischen Systems ist es bekannt, anstelle eines bisher eingesetzten Quarzoszillators einen hochgenauen Oszillator einzusetzen, was jedoch sehr kosten-und platzaufwendig ist. Durch das neue Verfahren wird es ermöglicht, eine Taktversorgung bereitzustellen, die kostengünstig ist und den gestellten Anforderungen an die Frequenzstabilität genügt.

Bei längerem Ausfall der externen Referenzfrequenz wird ein systeminternes Frequenz-Normal eingeschaltet, welches von der Takteinrichtung räumlich getrennt ist. Nach einer gewissen Aufheizzeit wird die Eingenfrequenz des Frequenz-Normals als eine interne Referenzfrequenz an die Takteinrichtung durchgeschaltet.

## Verfahren zur Synchronisation einer Takteinrichtung eines getakteten elektrischen Systems.

Die Erfindung betrifft ein Verfahren zur Synchronisation einer Takteinrichtung eines getakteten elektrischen Systems nach dem Oberbegriff des Anspruchs 1.

In synchronen digitalen Fernmeldenetzen werden die zentralen Taktgeneratoren der einzelnen digitalen Vermittlungen hierarchisch nach dem Master/Slave-Prinzip synchronisiert. Zu diesem Zweck ist innerhalb des zentralen Taktgenerators ein digitaler Phasenregelkreis vorhanden, der im wesentlichen aus einem Phasendiskriminator, einem Regler, einem spannungsgesteuerten Oszillator und einer Rückführungsschleife zur Zurückführung der herabgeteilten Ausgangsfrequenz des spannungsgesteuerten Oszillators auf einen ersten Eingang des Phasendiskriminators besteht. An dem zweiten Eingang des Phasendiskriminators liegt eine herabgeteilte externe Referenzfrequenz an.

Stehen für die Synchronisation eines zentralen Taktgenerators mehrere externe Referenzfrequenzen zur Verfügung, so wird bei Ausfall der momentan benutzten externen Referenzfrequenz auf eine andere noch intakte externe Referenzfrequenz umgeschaltet.

Durch den Regelprozeß ist die herabgeteilte Ausgangsfrequenz des spannungsgesteuerten Oszillators im Mittel exakt auf die herabgeteilte externe Referenzfrequenz eingestellt. Bei Ausfall sämtlicher externer Referenzfrequenzen wird die Ausgangsfrequenz des spannungsgesteuerten Oszillators mit dem letzten gesicherten Stellwert gehalten. Die Genauigkeit der Taktversorgung der betreffenden Vermittlung wird damit durch die Eigenstabilität des in dem genannten Phasenregelkreis eingesetzten spannungsgesteuerten Oszillators bestimmt, wobei Alterung und Temperaturabhängigkeit die wesentlichen Parameter darstellen.

Speziell die Temperaturstabilität der bisher bei digitalen Fernsprechvermittlungsstellen eingesetzten Quarzoszillatoren wirft bei längerem Ausfall der Referenzfrequenzen Probleme auf, wenn die bei CCITT und T1X1.3 diskutierten Grenzwerte in die relevanten Empfehlungen aufgenommen werden.

Eine bekannte Lösung für diesen Fall ist, zur Erfüllung der erhöhten Anforderungen anstelle des bisher bei digitalen Fernsprechvermittlungsstellen eingesetzten Quarzoszillators mit relativ geringer Eigenstabilität einen hochgenauen spannungsgesteuerten Oszillator (z.B. ein Rubidium-Normal in Verbindung mit Frequenz-Synthesizer) einzusetzen.

Diese Lösung ist jedoch sehr kosten- und platzaufwendig. Ein solcher erhöhter Platzbedarf macht zudem in bestimmten Fällen eine neue konstruktive Ausführungsform des Taktgenerators und daraufhin eventuell sogar des gesamten Systems, in dem der Taktgenerator integriert ist, nötig. Dies führt zu einer weiteren Erhöhung der Kosten.

Der Erfindung liegt die Aufgabe zugrunde, für getaktete elektrische Systeme, die nach dem Master/Slave-Prinzip synchronisiert werden, eine kostengünstige Taktversorgung bereitzustellen, die den gestellten Anforderungen an die Frequenzstabilität genügt.

Diese Aufgabe wird bei einem gattungsgemäßen Verfahren durch die kennzeichnenden Merkmale des Anspruchs 1 gelöst.

Ein mit der Erfindung erzielter Vorteil besteht darin, daß ein hochgenauer Oszillator nur in einem äußerst seltenen Betriebsfall eingeschaltet werden muß, was die Lebensdauer dieses Oszillators entsprechend erhöht.

Ein zweiter Vorteil besteht darin, daß der hochgenaue Oszillator im Falle eines aus Gründen der Betriebssicherheit gedoppelt ,vorgesehenen zentralen Taktgenerators nicht automatisch auch gedoppelt vorgesehen werden muß, da er räumlich getrennt von dem zentralen Taktgenerator eingebaut ist.

Ein dritter Vorteil steht in engem Zusammenhang damit, daß bestehende Fernmeldevermittlungsstellen möglichst ohne kostenspie lige Nachrüstung nachträglich erhöhten Anforderungen an die Frequenzstabilität ihrer Taktversorgung gerecht werden sollen. Dies ist mit der Erfindung dadurch erzielt, daß neben einem systeminternen Frequenz-Normal ein bisher verwendeter zentraler Taktgenerator mit nur geringfügigen Veränderungen, die keinen Einfluß auf seine konstruktive Integration in die Fernmeldevermittlungsstelle haben, weiter verwendet werden kann.

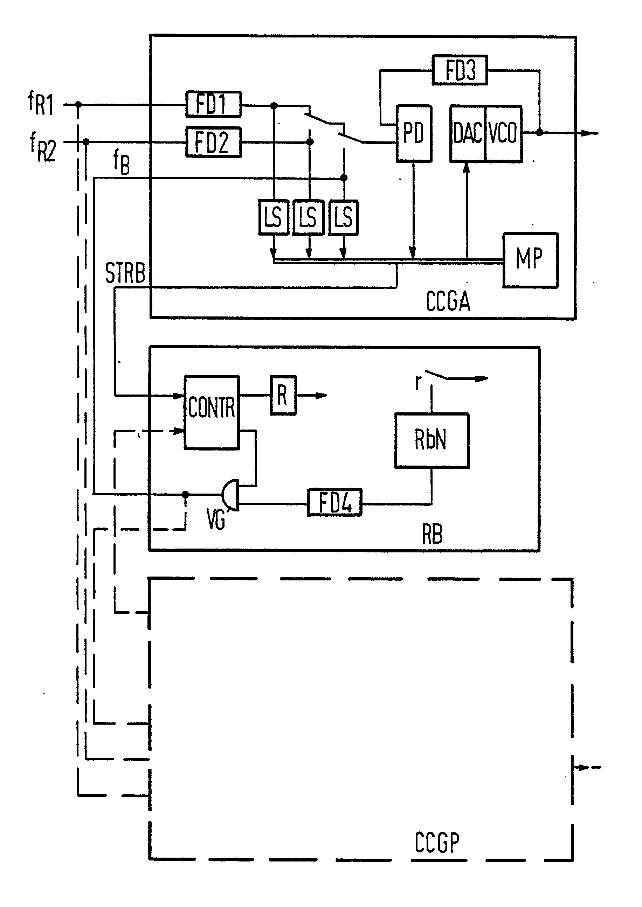

Ein Ausführungsbeispiel der Erfindung ist in der Zeichnung dargestellt und wird im folgenden näher beschrieben.

Die Figur zeigt die Takteinrichtung einer Vermittlungsstelle. Diese umfaßt einen zentralen Taktgenerator CCGA, der von einer ersten externen Referenzfrequenz $f_{R1}$ synchronisiert wird und bei Ausfall dieser Referenzfrequenz über einen ersten Schalter sl auf eine zweite externe Referenzfrequenz $f_{R2}$ umschaltet. Das Umschalten wird in der Figur durch einen Mikroprozessor MP veranlaßt, der die Information über den Ausfall einer Referenzfrequenz von einer Pegelüberwachung LS erhält. Der Mikroprozessor MP realisiert gleichzeitig den Regler des Phasenregelkreises, der im weiteren aus einem Phasendiskriminator PD, einem Digital-AnalogKonverter DAC, einem spannungsgesteuerten Oszillator VCO und einer Rückführungsschleife besteht, die die Ausgangsfrequenz des spannungsgesteuerten Oszillators VCO auf den ersten Eingang des Phasendiskriminators PD zurückführt. Ein erster Frequenzteiler FD1 und ein zweiter
Frequenzteiler FD2 teilen die erste externe Referenzfrequenz $f_{R1}$ und die zweite externe Referenzfrequenz $f_{R2}$ auf eine interne Vergleichsfrequenz $f_i$
herab. Ein dritter Frequenzteiler FD3 liegt in der
Rückführungsschleife des Phasenregelkreises und
teilt die Ausgangsfrequenz des spannungsgesteuerten Oszillaltors auf eine zweite interne Vergleichsfrequenz herab.

Der erste zentrale Taktgenerator CCGA umfaßt
außerdem einen Eingang für eine interne Referenzfrequenz $f_B$, die von einem Rubidium-Booster RB
geliefert wird, der sich an einem separaten Platz in
der Vermittlungsstelle befindet.

Bei Ausfall allerexternen Referenzfrequenzen
schaltet der zentrale Taktgenerator CCGA über einen zweiten Schalter s2 seinen Synchronisiereingang auf den Rubidium-Booster RB um und gibt
ein Anreizsignal STRB an eine Steuerung CONTR
des Rubidium-Boosters. Die Steuerung legt daraufhin über ein Relais R, das einen Schalter r betätigt,
Spannung an ein als Frequenz-Normal dienendes
Rubidium-Normal RbN. Nach einer Aufheizzeit von
ca. 20 Minuten hat das Rubidium-Normal RbN eine
Frequenzkonstanz besser als $1 \times 10^{-10}$ erreicht,
worauf die Steuerung CONTR über ein Verknüpfungsglied VG die über einen vierten Frequenzteiler FD4 herabgeteilte Eigenfrequenz des Rubidium-
Normals als die interne Referenzfrequenz $f_B$ freigibt.

Für die Dauer des Ausfalls der externen Referenzfrequenzen wird der erste zentrale Taktgenerator CCGA nun von dem Rubidium-Normal des
Rubidium-Boosters RB synchronisiert. Der erste
zentrale Taktgenerator braucht also nur noch die
Aufheizzeit des Rubidium-Normals mit ausreichender Frequenzkonstanz zu überbrücken.

Nach Wiederkehr von mindestens einer der
externen Referenzfrequenzen schaltet der erste
zentrale Taktgenerator CCGA auf diese Referenzfrequenz zurück und sperrt den Anreiz zum
Rubidium-Booster, worauf die Steuerung CONTR
des Rubidium-Boosters das RubidiumNormal RbN
wieder abschaltet.

Nie in der Figur durch gestrichelte Linien angedeutet, ist es zur Erhöhung der Betriebssicherheit
möglich, einen zweiten zentralen Taktgenerator
CCGP vorzusehen, der bei Ausfall des ersten zentralen Taktgenerators CCGA dessen Rolle übernimmt. Die interne Referenzfrequenzquelle
(Frequenz-Normal) braucht in diesem Fall jedoch
nicht gleichzeitig gedoppelt vorhanden sein, da sie
nur in einem äußerst seltenem Betriebsfall benötigt
wird, nämlich dann, wenn sämtliche externen Referenzfrequenzen über einen längeren Zeitraum ausfallen.

## Ansprüche

1. Verfahren zum Synchronisieren einer Takteinrichtung eines getakteten elektrischen Systems,
insbesondere eines zentralen Taktgenerators einer
digitalen Fernmeldevermittlungsstelle, die im Normalbetrieb von einer externen Referenzfrequenz
synchronisiert wird,
**dadurch gekennzeichnet,**
daß bei längerem Ausfall der externen Referenzfrequenz
a) ein systeminternes Frequenz-Normal eingeschaltet wird, welches von der Takteinrichtung
räumlich getrennt ist;
b) nach einer gewissen Aufheizzeit die Eigenfrequenz des Frequenz-Normals als eine interne Referenzfrequenz an die Takteinrichtung durchgeschaltet wird.

2. Verfahren nach Anspruch 1,
**dadurch gekennzeichnet,**
daß bei mehr als einer verfügbaren externen Referenzfrequenzfrequenz ($f_{R1}$; $f_{R2}$) das systeminterne
Frequenz-Normal nur dann eingeschaltet und später durchgeschaltet wird, wenn sämtliche externen
Referenzfrequenzen ($f_{R1}$; $f_{R2}$) ausgefallen sind.